# EUROPÄISCHE PATENTSCHRIFT

(11) **EP 1 708 292 B1**
(45) Veröffentlichungstag und Bekanntmachung des Hinweises auf die Patenterteilung: **10.09.2008**
(21) Anmeldenummer: 06110958.3
(22) Anmeldetag: 10.03.2006
(51) Int. Cl.: H01L 45/00

(54) **Anschlusselektrode für Phasen-Wechsel-Material, zugehöriges Phasen-Wechsel-Speicherelement sowie zugehöriges Herstellungsverfahren**
Connection electrode for phase change material, corresponding phase change memory element and production method thereof
Electrode de raccordement pour matériaux à changement de phase, élément de mémoire à changement de phase correspondant et procédé de fabrication associé

(30) Priorität: 31.03.2005 DE 102005014645
(43) Veröffentlichungstag der Anmeldung: 04.10.2006
(73) Patentinhaber: Qimonda AG, 81739 München (DE)
(72) Erfinder: Seidl, Harald, 85604, Pöring (DE)
(74) Vertreter: Kindermann, Peter

(56) Entgegenhaltungen:
- EP-A- 1 355 365
- EP-A2- 1 065 736
- WO-A-20/05053047
- US-A1- 2003 209 746
- US-A1- 2005 018 526

## Beschreibung

Die vorliegende Erfindung bezieht sich auf eine Anschlusselektrode für Phasen-Wechsel-Materialien, ein zugehöriges Phasen-Wechsel-Speicherelement sowie ein zugehöriges Herstellungsverfahren und insbesondere auf Anschlusselektroden, welche bei derartigen Speicherschaltungen besonders hohe Integrationsdichten ermöglichen.

Sogenannte Phasen-Wechsel-Speicherelemente (phase change memory elements) verwenden Materialien, die hinsichtlich ihrer elektrischen Eigenschaften eine reversible Umschaltbarkeit von einer Phase in eine andere Phase aufweisen. Beispielsweise wechseln derartige Materialien zwischen einer amorph geordneten Phase und einer kristallin oder polykristallin geordneten Phase. Insbesondere ein Widerstand bzw. ein Leitwert eines derartigen Materials ist in diesen zwei unterschiedlichen Phasenzuständen sehr verschieden.

In Phasen-Wechsel-Speicherelementen werden daher üblicherweise derartige Phasen-Wechsel-Materialien verwendet, die beispielsweise Legierungen von Elementen in der Gruppe VI des Periodensystems darstellen und als sogenannte Kalkogenide (chalcogenides) oder kalkogenische Materialien bezeichnet werden. Unter derartigen Phasen-Wechsel-Materialien werden demzufolge nachfolgend Materialien verstanden, die zwischen zwei unterschiedlichen Phasenzuständen mit unterschiedlichen elektrischen Eigenschaften (Widerständen) umgeschaltet werden können.

Die derzeit am weitesten verbreiteten Kalkogenide bzw. Phasen-Wechsel-Materialien bestehen aus einer Legierung von Ge, Sb und Te (GeₓSb_{y}Te_{z}). Ge₂Sb₂Te₅ wird bereits in einer Vielzahl von Phasen-Wechsel-Speicherelementen verwendet und ist darüber hinaus als Material für wiederbeschreibbare optische Speichermedien (z.B. CDs, DVDs usw.) bekannt.

Die Änderungen des Widerstandes von Phasen-Wechsel-Materialien werden genutzt, um beispielsweise nicht-flüchtige Speicherelemente (NVM, Non Volatile Memory) zu schaffen und Informationen zu speichern. In der amorphen Phase weisen demzufolge derartige Materialien einen höheren Widerstand auf als in der kristallinen oder polykristallinen Phase. Demzufolge kann ein Phasen-Wechsel-Material als programmierbarer Widerstand verwendet werden, dessen Widerstandsbetrag in Abhängigkeit von seinem Phasenzustand reversibel verändert werden kann.

Eine Übersicht derartiger Phasen-Wechsel-Materialien ist beispielsweise aus der Literaturstelle S. Hatkins et al.: "Overview of phase-change chalcogenide nonvolatile memory technology", MRS Bulletin/November 2004, Seiten 829 bis 832 bekannt.

Ein Wechsel der Phase in derartigen Materialien kann durch eine lokale Erhöhung einer Temperatur verursacht werden. Unter 150 Grad Celsius sind üblicherweise beide Phasenzustände stabil. Über 300 Grad Celsius erfolgt eine schnelle Kernbildung von Kristallen, weshalb man eine Änderung des Phasenzustandes in einen kristallinen oder polykristallinen Zustand erhält, sofern eine derartige Temperatur ausreichend lange vorliegt. Um den Phasenzustand wiederum in den amorphen Zustand zu bringen, wird die Temperatur über den Schmelzpunkt von ca. 600 Grad Celsius gebracht und sehr schnell abgekühlt. Beide kritischen Temperaturen, sowohl für die Kristallisierung als auch für das Schmelzen, können unter Verwendung eines elektrischen Stromes erzeugt werden, der durch eine elektrisch leitende Anschlusselektrode mit einem vorbestimmten Widerstand fließt und in Kontakt oder in der Nähe des Phasen-Wechsel-Materials ist. Die Erwärmung erfolgt hierbei durch sogenannte Joule'sche Erwärmung.

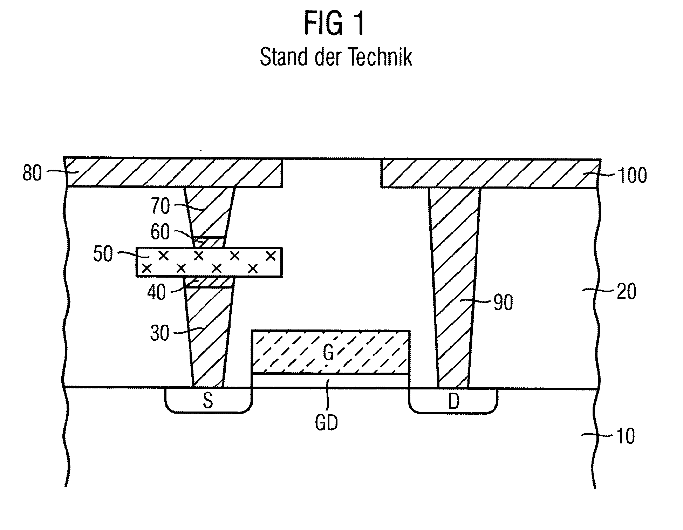

Figur 1 zeigt eine vereinfachte Schnittansicht eines Phasen-Wechsel-Speicherelements gemäß dem Stand der Technik, wobei in einem Halbleitersubstrat 10 ein Halbleiterschaltelement wie beispielsweise ein Feldeffekttransistor mit einem Sourcegebiet S, einem Draingebiet D und einem Gate G ausgebildet ist, das über einem Gatedielektrikum GD liegt. Das Sourcegebiet S ist beispielsweise über ein Anschlusselement 30 mit einer Anschlusselektrode 40 verbunden, die das Phasen-Wechsel-Material 50 mit den vorstehend beschriebenen Eigenschaften kontaktiert. An der gegenüber liegenden Hauptoberfläche des Phasen-Wechsel-Materials 50 ist eine weitere Anschlussgegenelektrode 60 vorgesehen, die über ein weiteres Anschlusselement 70 elektrisch mit einer Leitbahn 80 in Verbindung steht. Ferner kann das Draingebiet D ebenfalls über ein Anschlusselement 90 an eine Leitbahn 100 angeschlossen sein.

Das Bezugszeichen 20 bezeichnet ein isolierendes Zwischendielektrikum. Der Abschnitt des Phasen-Wechsel-Materials 50, der mit den Anschlusselektroden 40 und 60 in unmittelbarem Kontakt steht, definiert den effektiven Phasen-Wechsel-Bereich des kalkogeniden Materials.

Wird nunmehr ein elektrischer Strom mit einem ausreichend hohen Betrag durch die Anschlusselektrode 40 geschickt, so kann dieser Phasen-Wechsel-Abschnitt des Phasen-Wechsel-Materials 50 eine entsprechende Kristallisierungs-Erwärmung oder Schmelz-Erwärmung aufweisen, wodurch ein Phasenwechsel verursacht wird. Hierbei benötigt die Amorphisierung des Phasen-Wechsel-Materials lediglich eine kurze Zeit (kurzer Stromimpuls) jedoch eine hohe Temperatur (hoher Strombetrag), während für die Kristallisierung für eine längere Zeitdauer ein geringerer Strom anliegen muss.

Das Auslesen des eingestellten Phasenzustandes kann durch Anlegen einer ausreichend geringen Lese-Spannung durchgeführt werden, welche keine kritische Erwärmung verursacht. Da der gemessene Strom proportional zur Leitfähigkeit bzw. zum Widerstand des Phasen-Wechsel-Materials ist, können die derart eingestellten Phasenzustände zuverlässig erfasst werden. Da darüber hinaus das Phasen-Wechsel-Material nahezu beliebig oft elektrisch umgeschaltet werden kann, können sehr einfach nicht-flüchtige Speicherelemente erzeugt werden.

Zur Vermeidung von Störungen zwischen benachbarten Speicherelementen werden gemäß Figur 1 Phasen-Wechsel-Speicherelemente üblicherweise mit einem Auswahlelement wie beispielsweise dem dargestellten Feldeffekttransistor realisiert. Dieses Auswahlelement kann jedoch in gleicher Weise auch ein nicht dargestellter Bipolartransistor, eine Diode oder ein sonstiges Schaltelement sein.

Nachteilig sind jedoch bei derartigen Speicherelementen die sehr hohen Programmierströme, welche für die Änderung des Phasenzustandes erforderlich sind. Insbesondere in Halbleiterschaltungen mit sehr hohen Integrationsdichten sind derartige Ströme jedoch stark begrenzt, wobei z.B. bei Gatelängen von ca. 100 nm und einem verwendeten Gatedielektrikum, welches einer Spannung von 3 V widersteht, maximale Ströme von 100 bis 200 µA zur Verfügung stehen. Dadurch ergeben sich Kontaktflächen zum Phasen-Wechsel-Material von maximal 20 nm x 20 nm, welche weit unterhalb von lithographisch realisierbaren Strukturen liegen.

Zur Erzielung derartiger hoher Stromdichten bzw. kleiner Kontaktflächen ist aus der US 6 746 892 B2 beispielsweise bekannt Anschlusselektroden zu verwenden, die eine spitze Form aufweisen.

Ferner ist aus der US 2003/0209746 A1 eine Anschlusselektrode bekannt, bei der eine lithographisch strukturierte Anschlussfläche für ein Phasen-Wechsel-Material durch Spacer derart verkleinert wird, dass sich wiederum eine sehr kleine Kontaktfläche und insbesondere eine sublithographische Kontaktfläche der Anschlusselektrode zum Phasen-Wechsel-Material realisieren lässt.

Eine präzise Einstellung der tatsächlich wirkenden Kontaktfläche zwischen Anschlusselektrode und Phasen-Wechsel-Material ist jedoch dadurch nicht möglich.

Der Erfindung liegt daher die Aufgabe zu Grunde eine Anschlusselektrode für Phasen-Wechsel-Materialien, ein zugehöriges Phasen-Wechsel-Speicherelement sowie ein zugehöriges Herstellungsverfahren zu schaffen, wobei eine effektive Kontaktfläche und somit eine räumliche Begrenzung des Strompfads hochgenau eingestellt werden kann.

Erfindungsgemäß wird diese Aufgabe hinsichtlich der Anschlusselektrode durch die Merkmale des Patentanspruchs 1, hinsichtlich des Phasen-Wechsel-Speicherelements durch die Merkmale des Patentanspruchs 7 und hinsichtlich des Herstellungsverfahrens durch die Maßnahmen des Patentanspruchs 10 gelöst.

Erfindungemäß weist demzufolge ein Elektrodenmaterial der Anschlusselektrode eine Vielzahl von Isolationsgebieten auf, die zumindest an der Anschlussoberfläche zum Phasen-Wechsel-Material ausgebildet sind.

Vorzugsweise ist hierbei das Elektrodenmaterial lithographisch strukturiert, während die Isolationsgebiete sublithographisch ausgebildet werden.

Die Isolationsgebiete weisen hierbei vorzugsweise einen kornförmigen Oberflächenquerschnitt auf, wobei sie aus SiO₂ bestehen, während das Elektrodenmaterial TiN aufweist.

Hinsichtlich des Phasen-Wechsel-Speicherelements wird die Anschlusselektrode vorzugsweise in einem Kontaktloch eines Dielektrikums ausgebildet, wobei das Phasen-Wechsel-Material entweder an der Oberfläche des Dielektrikums außerhalb des Kontaktlochs oder nur an der Oberfläche der Anschlusselektrode innerhalb des Kontaktlochs ausgebildet ist.

Hinsichtlich des Verfahrens zur Herstellung eines Phasen-Wechsel-Speicherelements werden vorzugsweise eine Vielzahl von Maskierungselementen an der Oberfläche eines Hilfsdielektrikums ausgebildet, wobei in einem nachfolgenden Schritt von den Maskierungselementen nicht bedeckte Bereiche des Hilfsdielektrikums zum Ausbilden einer Vielzahl von Isolationsgebieten anisotrop rückgeätzt werden und die dadurch entstehenden freiliegenden Bereiche mit einem Elektrodenmaterial zum Ausbilden einer Anschlusselektrode aufgefüllt werden.

Vorzugsweise werden die Maskierungselemente sublithographisch ausgebildet, wobei insbesondere sogenannte LPCVD-Verfahren zur Herstellung von Halbleiter-Nanokristallen oder HSG-Verfahren zur Herstellung von HSG-Körnern (Hemispherical Silicon Grains) verwendet werden.

Als Elektrodenmaterial wird insbesondere TiN konformal mittels eines ALD-Verfahrens ganzflächig abgeschieden und von einer gemeinsamen Oberfläche des Dielektrikums und der Isolationsgebiete entfernt.

Alternativ kann die Anschlusselektrode auch bis zu einer vorbestimmten Tiefe im Kontaktloch zurückgeätzt werden und das Phasen-Wechsel-Material nur in dieser Vertiefung ausgebildet werden, wodurch sich ein selbstjustierendes Verfahren mit maximaler Integrationsdichte ergibt.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figur 1 eine vereinfachte Schnittansicht eines Phasen-Wechsel-Speicherelements gemäß dem Stand der Technik;
Figuren 2A bis 2G vereinfachte Schnittansichten und eine Draufsicht zur Veranschaulichung wesentlicher Herstellungsschritte bei der Realisierung eines Phasen-Wechsel-Speicherelements mit erfindungsgemäßer Anschlusselektrode gemäß einem ersten Ausführungsbeispiel; und
Figur 3 eine vereinfachte Schnittansicht zur Veranschaulichung eines Phasen-Wechsel-Speicherelements mit erfindungsgemäßer Anschlusselektrode gemäß einem zweiten Ausführungsbeispiel.

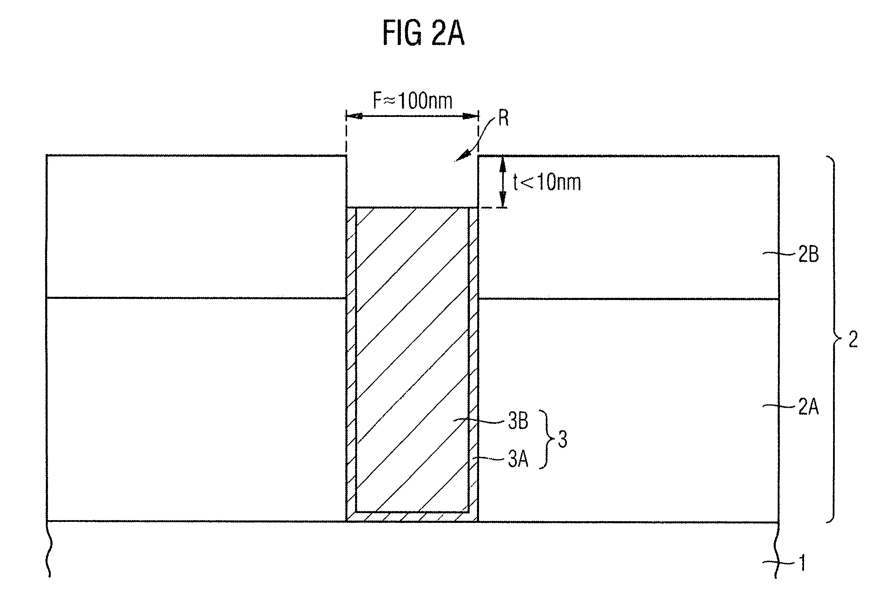

Figuren 2A bis 2G zeigen vereinfachte Schnittansichten sowie eine Draufsicht zur Veranschaulichung eines Verfahrens zur Herstellung einer Anschlusselektrode für Phasen-Wechsel-Materialien und insbesondere für ein Phasen-Wechsel-Speicherelement, wie es beispielsweise in einer Phasen-Wechsel-Speicherzelle gemäß Figur 1 eingesetzt werden kann.

Gemäß Figur 2A wird zunächst auf einer Trägerschicht 1 ein Dielektrikum 2 ausgebildet, wobei die Trägerschicht 1 vorzugsweise ein einkristallines Si-Halbleitersubstrat aufweist und das Dielektrikum 2 einen Mehrschichtenaufbau besitzt. Genauer gesagt wird als erste Isolationsschicht 2A beispielsweise eine SiO₂-Schicht an der Oberfläche der Trägerschicht 1 bzw. des Si-Halbleitersubstrats abgeschieden oder thermisch ausgebildet und anschließend an der Oberfläche der ersten Isolationsschicht 2A eine beispielsweise aus Si₃N₄ bestehende zweite Isolationsschicht 2B ganzflächig abgeschieden. Der Vorteil dieser Doppelschicht liegt darin, dass die zweite Isolationsschicht 2B in einem späteren Verfahrensschritt als Ätzstoppschicht verwendet werden kann.

Grundsätzlich sind auch andere Isolationsschichten und insbesondere alternative zwischendielektrische Schichten als Dielektrikum 2 zu verwenden. In gleicher Weise kann die Trägerschicht 1 auch eine Metallisierungsebene oder eine sonstige vorzugsweise elektrisch leitende Schicht darstellen.

Zur Realisierung einer elektrischen Verbindung zu einem im Halbleitermaterial ausgebildeten Auswahlelement wie beispielsweise dem Sourcegebiet S gemäß Figur 1 wird anschließend mittels herkömmlicher lithographischer Verfahren ein Kontaktloch im Dielektrikum 2 bzw. die erste und zweite Isolationsschicht 2A und 2B ausgebildet. Vorzugsweise besitzt das Kontaktloch eine Ausdehnung F, wobei F eine minimale lithographisch realisierbare Strukturbreite festlegt. Das Kontaktloch kann beispielsweise eine rechteckige, quadratische, kreisrunde oder ovale Form aufweisen. Üblicherweise werden zum Ausbilden dieses Kontaktlochs Standard-Ätzverfahren verwendet, weshalb auf eine detaillierte Beschreibung nachfolgend verzichtet wird.

Gemäß Figur 2A wird innerhalb dieses Kontaktlochs bzw. der Öffnung im Dielektrikum 2 nunmehr ein Anschlusselement 3 ausgebildet. Beispielsweise wird an der Oberfläche des Kontaktlochs bzw. der Öffnung, d.h. an den Seitenflächen der Isolationsschichten 2A und 2B sowie dem Bodenbereich eine dünne Linerschicht abgeschieden und thermisch ausgeheilt. Vorzugsweise wird eine Ti/TiN-Liner-Doppelschicht mit einer Schichtdicke von 10nm/10nm mit gleicher Schichtdicke, d.h. konformal, abgeschieden und bei einer vorbestimmten Temperatur ausgeheilt, wodurch man eine zuverlässige Barrierenschicht zur Verhinderung einer Ausdiffusion von Verunreinigungen in das Halbleitermaterial bzw. die Trägerschicht 1 erhält.

Nach dieser Liner-Abscheidung erfolgt ein Auffüllen der Öffnung bzw. des Kontaktlochs mit einer elektrisch leitenden Füllschicht 3B, wobei vorzugsweise Wolfram ganzflächig abgeschieden und bis zu einer vorbestimmten Tiefe (z.B. 10nm) in die Öffnung bzw. in das Kontaktloch hinein zurückgeätzt wird. Eine derartige Rückätzung kann beispielsweise mittels eines Trockenätzverfahrens und insbesondere mittels reaktiven Ionenätzens (RIE, Reactive Ion Etch) durchgeführt werden. Ferner kann in diesem oberen Abschnitt auch die Linerschicht 3A an den Seitenwänden des Kontaktlochs entfernt werden, wodurch man die in Figur 2A dargestellte Vertiefung R im Kontaktloch bzw. der Öffnung erhält. Vorzugsweise wird für das Entfernen der Linerschicht 3A ein isotropes und insbesondere ein nasschemisches Ätzverfahren angewendet. Grundsätzlich können jedoch auch trockenchemische bzw. gerichtete Ätzverfahren durchgeführt werden. Grundsätzlich kann die Vertiefung R auch eine vom Kontaktloch verschiedene Abmessung aufweisen, wobei sie zur Realisierung der erforderlichen hohen Stromdichten vorzugsweise eine minimale mittels lithographischer Verfahren realisierbare Strukturbreite F aufweist.

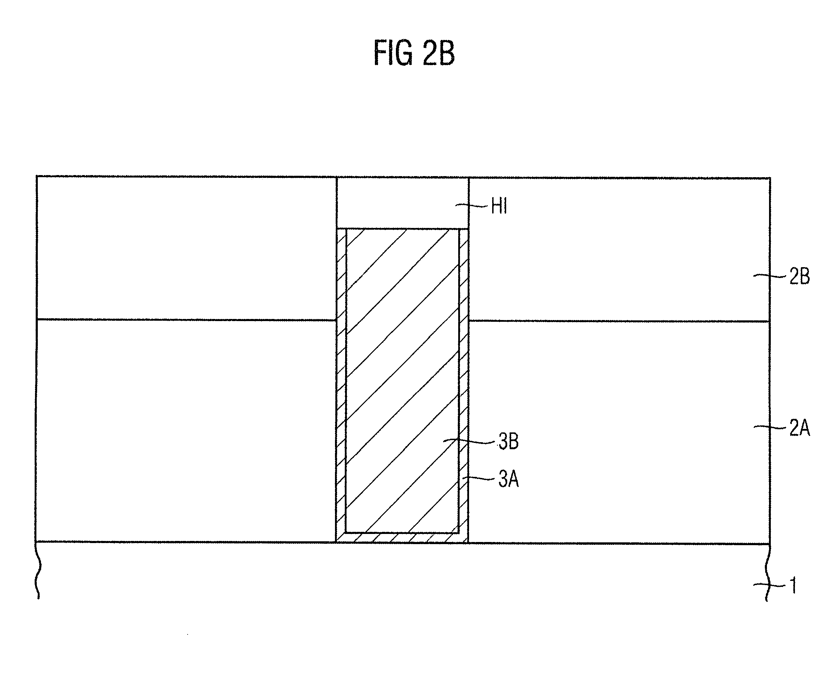

Gemäß Figur 2B wird nunmehr in der Vertiefung R ein Hilfsdielektrikum HI aufgefüllt. Vorzugsweise wird hierbei mittels eines CVD-Verfahrens (Chemical Vapor Deposition) SiO₂ ganzflächig abgeschieden und anschließend bis zur Oberfläche des Dielektrikums 2 bzw. der zweiten Isolationsschicht 2B planarisiert. Bei einer typischen Tiefe von ca. 10 nm der Vertiefung R wird daher eine mindestens 10 nm dicke SiO₂-Schicht abgeschieden und planarisiert. Bei derzeit minimalen lithographisch herstellbaren Strukturbreiten von F = 100 nm ergibt sich für die Vertiefung R somit ein Seitenverhältnis von 1:10.

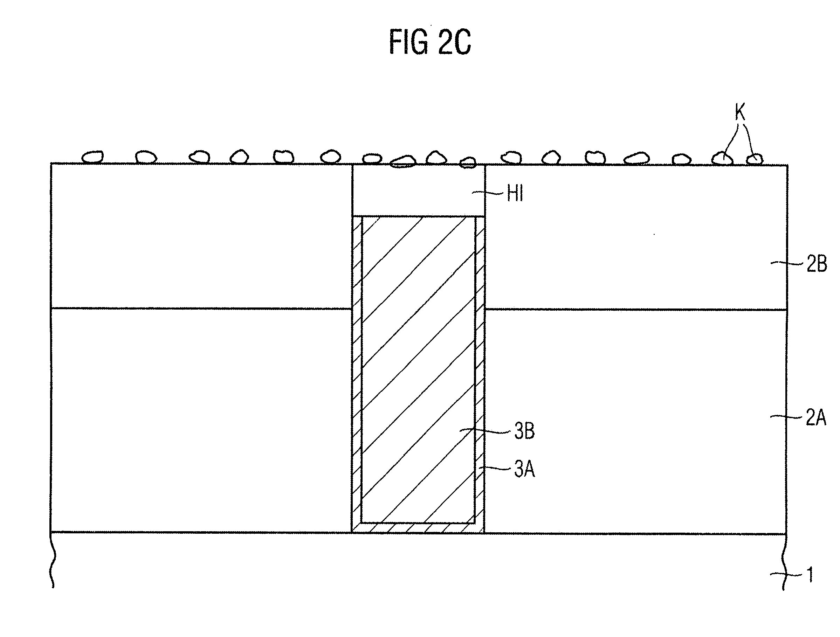

Gemäß Figur 2C werden nunmehr eine Vielzahl von einander beabstandeter Maskierungselementen K zumindest an der Oberfläche des Hilfsdielektrikums HI ausgebildet. Vorzugsweise werden diese voneinander getrennten Maskierungselemente K sublithographisch ausgebildet bzw. weisen ihre Strukturgrößen sublithographische Abmessungen auf, weshalb sie eine Strukturbreite von 1 bis 15 nm aufweisen sollten. Zur Herstellung derartiger Maskierungselemente K ist beispielsweise das sogenannte HSG-Verfahren (Hemispherical Silicon Grain) bekannt, bei dem Siliziumkörner mit einer Größe von 5 bis 15 nm ganzflächig an der Oberfläche des Dielektrikums 2 sowie des Hilfsdielektrikums HI ausgebildet werden. Obwohl mit diesem insbesondere aus der DRAM-Herstellung bekannten Verfahren zur Oberflächenvergrößerung von Speicherkondensatoren bereits sehr brauchbare Maskierungselemente K hergestellt werden können, wird nachfolgend vorzugsweise ein sogenanntes LPCVD-Verfahren zur Herstellung von Si-Nanokristallen verwendet. Ein derartiges Verfahren ist beispielsweise aus der Literaturstelle De Salvo et al.: "How far will Silicon nanocrystals push the scaling limits of NVMs technologies?" IEDM 2003, bekannt.

Mittels dieses Verfahrens können Nanokristalle bzw. sogenannte Nanodots als Maskierungselemente K erzeugt werden, die eine Strukturgröße von 1 nm bis 10 nm aufweisen. Hierbei lässt sich neben der jeweiligen Größe dieser Nanodots bzw. Maskierungselemente K auch eine Flächendichte sehr gut einstellen bzw. variieren, was zur exakten Einstellung einer letztlich effektiven Anschlusselektrodenfläche von Bedeutung ist. Vorzugsweise ist die Größe der Nanodots bzw. Maskierungselementen K um mindestens eine Größenordnung kleiner als eine Strukturbreite der Öffnung bzw. des Kontaktlochs, d.h. die kornförmigen Maskierungselemente K weisen eine Strukturbreite kleiner 1/10 F auf.

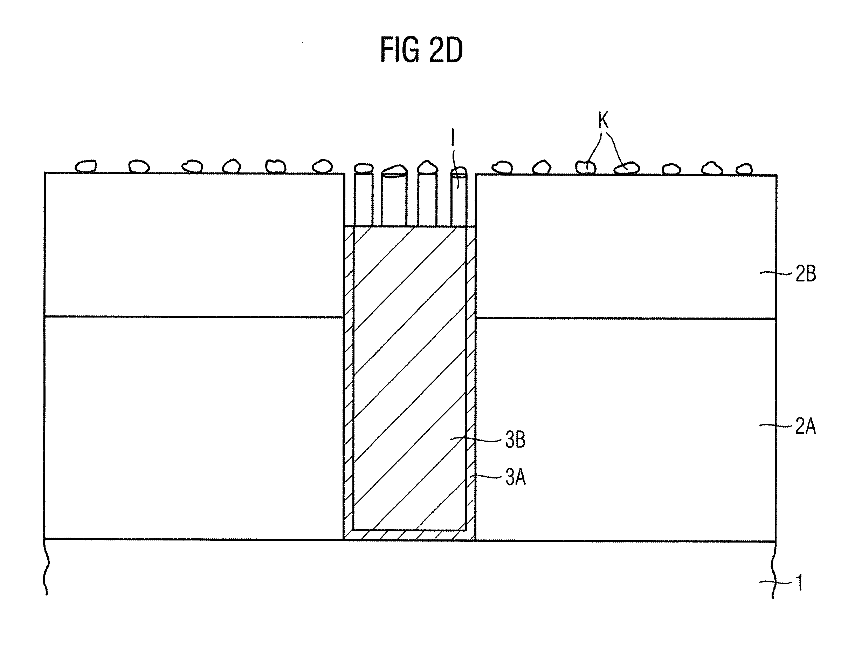

Gemäß Figur 2D kann nunmehr ein anisotropes Rückätzen des von den Maskierungselementen K nicht bedeckten Bereiches des Hilfsdielektrikums HI bis zum Anschlusselement 3 der Füllschicht 3B und der Linerschicht 3A erfolgen. Auf diese Weise werden eine Vielzahl von voneinander getrennten Isolationsgebieten I sozusagen "inselförmig" ausgebildet. Auf Grund der Verwendung der Si₃N₄-Isolationsschicht 2B kann selektiv zum Material der Maskierungselemente K, d.h. zum Silizium und zum Material der zweiten Isolationsschicht 2B eine gerichtete Rückätzung des Hilfsdielektrikums HI mit Standard-Ätzverfahren durchgeführt werden, welches vorzugsweise aus SiO₂ besteht. Grundsätzlich kann auch eine ungerichtete oder nur teilweise gerichtete Ätzung durchgeführt werden, wodurch die Form der Isolationsgebiete beeinflusst werden kann.

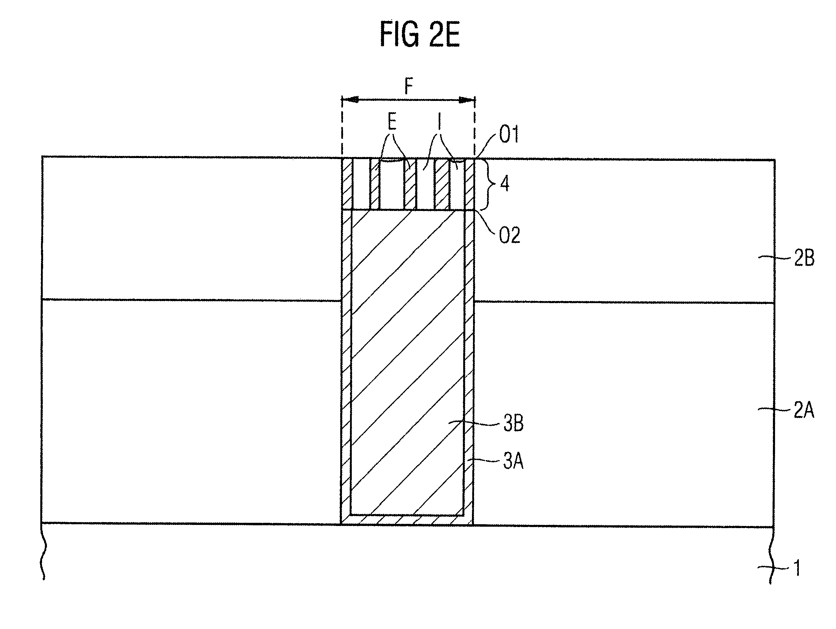

Gemäß Figur 2E können in einem nachfolgenden Schritt die an der Oberfläche befindlichen Maskierungselemente K (Nanodots oder HSG-Körner) selektiv zum Hilfsdielektrikum HI, zum Anschlusselement 3 und zur zweiten Isolationsschicht 2B bzw. dem Dielektrikum 2 entfernt werden. Grundsätzlich können neben derartigen nasschemische Ätzverfahren auch CMP-Verfahren (Chemical Mechanical Polishing) durchgeführt werden.

Ferner wird gemäß Figur 2E nunmehr ein durch das z.B. anisotrope Rückätzen freigelegter Zwischenraum zwischen den Isolationsgebieten I mit einem Elektrodenmaterial E zum Ausbilden einer Anschlusselektrode 4 aufgefüllt. Vorzugsweise kann TiN als Elektrodenmaterial E konformal und insbesondere mittels eines ALD-Verfahrens (Atomic Layer Deposition) ganzflächig abgeschieden und abschließend von der gemeinsamen Oberfläche des Dielektrikums 2 und der Isolationsgebiete I entfernt werden. Dieses Entfernen geschieht vorzugsweise mittels eines Planarisierungsverfahrens wie beispielsweise eines CMP-Verfahrens. Wiederum ist lediglich eine Selektivität gegenüber der zweiten Isolationsschicht 2B und dem Material der Isolationsgebiete I erforderlich.

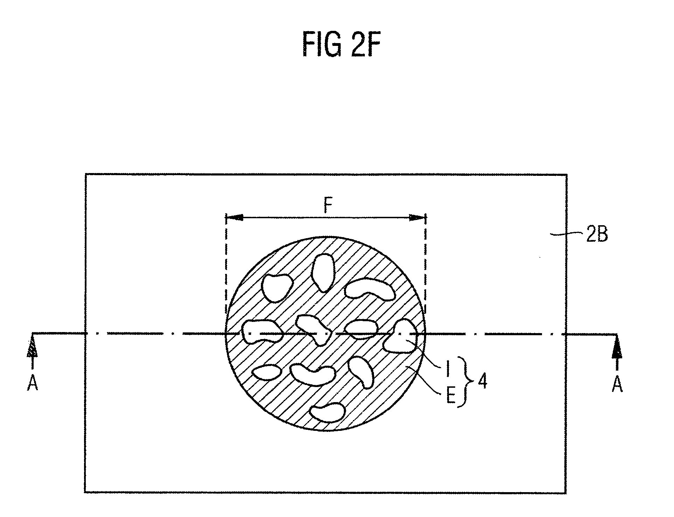

Figur 2F zeigt eine vereinfachte Draufsicht der Anschlusselektrode 4, wie sie nach dem Herstellungsschritt gemäß Figur 2E vorliegt. Demzufolge weist die Anschlusselektrode 4 ein Elektrodenmaterial E auf, dessen Grundform vorzugsweise lithographisch durch das Kontaktloch festgelegt ist und in dem eine Vielzahl von Isolationsgebieten I zumindest an der Anschlussoberfläche zu einem Phasen-Wechsel-Material ausgebildet bzw. eingelagert sind. Die vorzugsweise sublithographisch ausgebildeten Isolationsgebiete I stellen somit eine Vielzahl von vorzugsweise voneinander getrennten Inseln in einem "See" des Elektrodenmaterials E dar. Auf Grund der verwendeten sublithographischen Verfahren und insbesondere des HSG-Verfahrens und des LPCVD-Si-Nanokristall-Verfahrens weisen die Isolationsgebiete I eine für diese Herstellungsverfahren charakteristische kornförmige Struktur an der Anschlussoberfläche auf. Demgegenüber besitzen gemäß Figur 2E die Isolationsgebiete im Querschnitt zur Anschlussoberfläche eine zylinderförmige Struktur auf, welche sich im Wesentlichen aus dem gerichteten Ätzprozess ergibt.

Obwohl sich gemäß Figuren 2E und 2F die Isolationsgebiete I von der Anschlussoberfläche 01 bis zu einer gegenüber liegenden Hauptoberfläche 02 erstrecken und folglich "inselförmig" ausgebildet sind, können sie auch lediglich an der Anschlussoberfläche O1 ausgebildet sein und somit auf dem Elektrodenmaterial E "schwimmen". Eine derartige Realisierungsform kann sich beispielsweise bei Verwendung eines isotropen oder teilisotropen Ätzverfahrens ergeben, bei dem nur unmittelbar unterhalb der Maskierungskörner K Isolationsmaterial bestehen bleibt und ansonsten entfernt wird. Grundsätzlich können sich alle oder nur einzelne Isolationsgebiete I auch berühren, wodurch eine "netzförmige"" Struktur der Isolationsgebiete I entsteht.

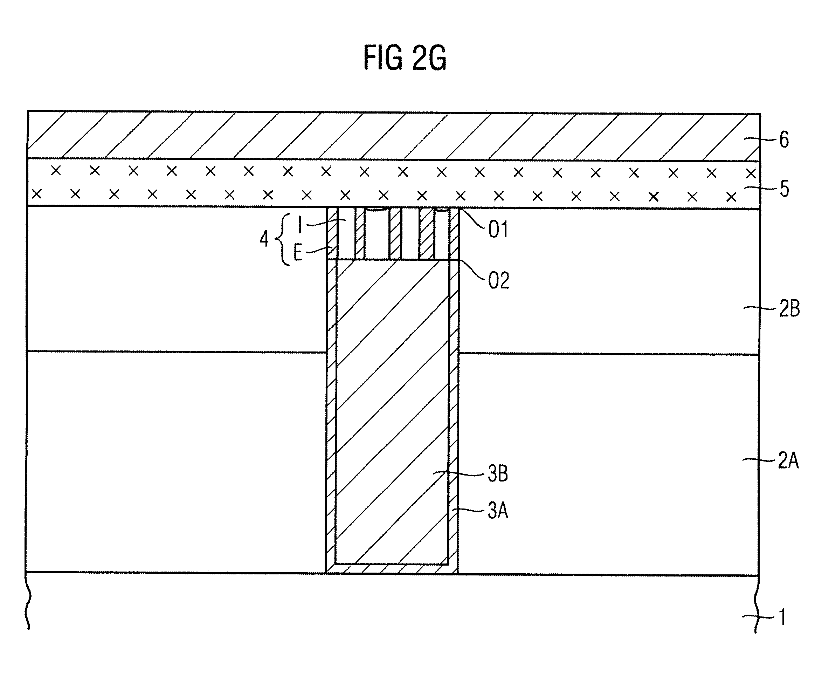

Gemäß Figur 2G wird nunmehr ein Phasen-Wechsel-Material 5 zumindest an der Oberfläche der Anschlusselektrode 4 ausgebildet. Gemäß dem ersten Ausführungsbeispiel wird vorzugsweise GeₓSb_{y}Te_{z} z.B. mittels eines PVD- oder CVD-Verfahrens ganzflächig abgeschieden, wobei jedoch auch ALD-Verfahren (Atomic Layer Deposition) verwendet werden können. Abschließend wird an der der Anschlusselektrode 4 gegenüber liegenden Hauptoberfläche des Phasen-Wechsel-Materials 5 eine Anschlussgegenelektrode 6 ausgebildet. Vorzugsweise wird hierbei TiN ganzflächig wiederum mittels eines PVD-, CVD- oder ALD-Verfahrens abgeschieden.

Die Vervollständigung einer derartigen nicht flüchtigen Speicherzelle erfolgt dann gemäß dem Stand der Technik, wie z.B. in Figur 1 dargestellt.

Auf diese Weise erhält man eine Anschlusselektrode 4 sowie ein zugehöriges Phasen-Wechsel-Speicherelement sowie ein zugehöriges Herstellungsverfahren, bei dem der benötigte Schaltstrom sich durch die räumliche Begrenzung des Strompfades sehr genau verringern und einstellen lässt, weshalb auch bei hohen Integrationsdichten die erforderlichen jouleschen Erwärmungen mit sehr geringen Stromstärken realisierbar sind.

Die Variation der Anschlusselektroden-Querschnittsfläche lässt sich insbesondere bei Verwendung von LPCVD-Si-Nanokristall-Verfahren sehr genau durch Variation der Größe und Dichte der Nanodots einstellen. Auf Grund der statistischen Verteilung der Nanodots ergibt sich eine sehr gleichmäßige Verteilung des Stromflusses über die Kontaktfläche der Anschlusselektrode, weshalb man eine sehr hohe Skalierbarkeit des Prozesses unabhängig von einer verwendeten Lithographie und den verwendeten Nanodotgrößen erhält.

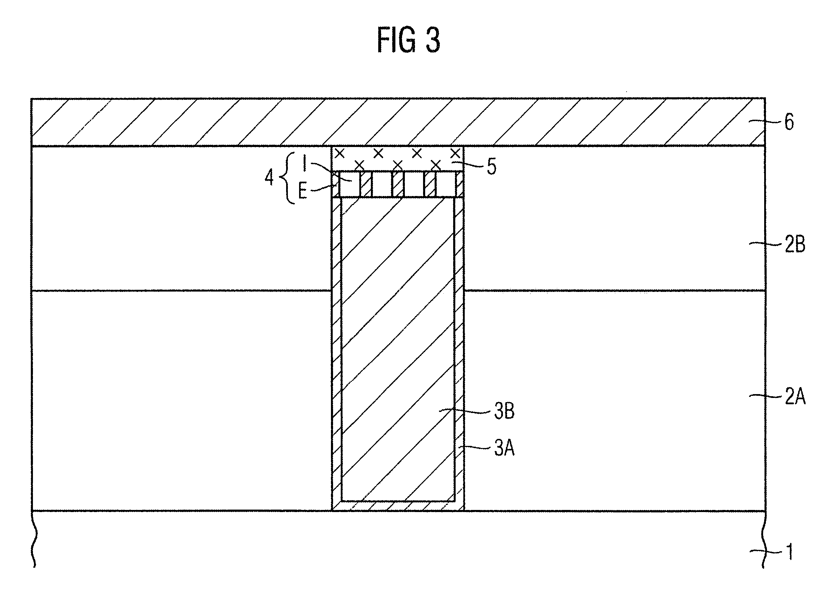

Figur 3 zeigt eine vereinfachte Schnittansicht eines Phasen-Wechsel-Speicherelements gemäß einem zweiten Ausführungsbeispiel, wobei gleiche Bezugszeichen gleiche oder entsprechende Schichten und Elemente wie in den Figur 2A bis 2G bezeichnen, weshalb auf eine wiederholte Beschreibung nachfolgend verzichtet wird.

Gemäß diesem zweiten Ausführungsbeispiel wird nach einem Schritt gemäß Figur 2E ein oberer Abschnitt der Anschlusselektrode 4 entfernt bzw. die SiO₂-Isolationsgebiete I und das TiN-Elektrodenmaterial E bis zu einer vorbestimmten Tiefe, die etwa einer halben Höhe der ursprünglichen Anschlusselektrode entspricht, in das Kontakloch zurückgeätzt. Anschließend wird wiederum mittels eines ALD-, CVD-, PVD-Verfahrens ein Phasen-Wechsel-Material 5 und insbesondere GeₓSb_{y}Te_{z} ganzflächig abgeschieden und bis zu Oberfläche des Dielektrikums 2 bzw. der zweiten Isolationsschicht 2B planarisiert.

Abschließend wird wie beim ersten Ausführungsbeispiel gemäß Figur 2G eine Anschlussgegenelektrode 6 vorzugsweise aus TiN ganzflächig abgeschieden. Die Dicke des Phasen-Wechsel-Materials 5 gemäß Figur 3 sollte typischerweise ≥ 10 nm sein, wobei die Anschlusselektrode 4 ebenfalls eine Dicke von ca. 10 nm aufweist. Wiederum kann eine Phasen-Wechsel-Speicherzelle mit den üblichen Verfahren beispielsweise gemäß Figur 1 fertiggestellt werden.

Die Erfindung wurde vorstehend anhand von GeₓSb_{y}Te_{z} als Phasen-Wechsel-Material beschrieben. Sie ist jedoch nicht darauf beschränkt und umfasst in gleicher Weise auch alternative Phasen-Wechsel-Materialien.

In gleicher Weise sind die weiteren Materialien nicht auf die vorstehend beschriebenen Materialien beschränkt sondern können alternative Materialien umfassen. Insbesondere muss das Dielektrikum 2 keinen Mehrschichtaufbau aufweisen.

Ferner ist die Erfindung nicht auf ein Si-Halbleitersubstrat als Trägerschicht 1 beschränkt, sondern kann in gleicher Weise auch auf sonstigen Trägerschichten und insbesondere in darüber liegenden Verdrahtungsschichten ausgebildet sein.

## Patentansprüche

1. Anschlusselektrode für Phasen-Wechsel-Material mit einem elektrisch leitenden Elektrodenmaterial (E), welches zumindest eine Anschlussoberfläche (O1) für das Phasen-Wechsel-Material aufweist,
**dadurch gekennzeichnet, dass** eine Vielzahl von Isolationsgebieten (I) innerhalb des Elektrodenmaterials (E) und zumindest an deren Anschlussoberfläche (O1) zum Verringern einer Gesamtkontaktfläche ausgebildet sind.

2. Anschlusselektrode nach Patentanspruch 1,
**dadurch gekennzeichnet, dass** die Isolationsgebiete (I) sublithographisch strukturiert sind und das Elektrodenmaterial (E) zusammenhängend zwischen den Isolationsgebieten (I) ausgebildet ist.

3. Anschlusselektrode nach einem der Patentansprüche 1 oder 2,
**dadurch gekennzeichnet, dass** sich die Isolationsgebiete (I) von der Anschlussoberfläche (O1) bis zu einer gegenüberliegenden Hauptoberfläche (02) erstrecken.

4. Anschlusselektrode nach einem der Patentansprüche 1 bis 3,
**dadurch gekennzeichnet, dass** die Isolationsgebiete (I) an der Anschlussoberfläche (01) eine kornförmige Struktur aufweisen.

5. Anschlusselektrode nach einem der Patentansprüche 3 oder 4,
**dadurch gekennzeichnet, dass** die Isolationsgebiete (I) im Querschnitt zur Anschlussoberfläche (O1) eine zylinderförmige Struktur aufweisen.

6. Anschlusselektrode nach einem der Patentansprüche 1 bis 5,
**dadurch gekennzeichnet, dass** die Isolationsgebiete (I) SiO₂ und das Elektrodenmaterial (E) TiN aufweisen.

7. Phasen-Wechsel-Speicherelement mit
einer Trägerschicht (1);
einem Anschlusselement (3), das mit der Trägerschicht (1) elektrisch verbunden ist;
einer Anschlusselektrode (4) mit einer Anschlussoberfläche (O1) und einer dazu gegenüber liegenden Hauptoberfläche (02), die mit dem Anschlusselement (3) elektrisch verbunden ist;
einem Phasen-Wechsel-Material (5), das an der Anschlussoberfläche (O1) ausgebildet ist; und
einer Anschlussgegenelektrode (6), die der Anschlusselektrode (4) gegenüberliegend auf dem Phasen-Wechsel-Material (5) ausgebildet ist,
**dadurch gekennzeichnet, dass** die Anschlusselektrode (4) und/oder die Anschlussgegenelektrode (6) gemäß einem der Patentansprüche 1 bis 6 ausgebildet ist.

8. Phasen-Wechsel-Speicherelement nach Patentanspruch 7, **dadurch gekennzeichnet, dass** das Anschlusselement (3) und die Anschlusselektrode (4) in einem Kontaktloch eines Dielektrikums (2) ausgebildet ist, und das Phasen-Wechsel-Material (5) an der gemeinsamen Oberfläche des Dielektrikums 2 und der Anschlusselektrode (4) ausgebildet ist.

9. Phasen-Wechsel-Speicherelement nach Patentanspruch 7, **dadurch gekennzeichnet, dass** das Anschlusselement (3), die Anschlusselektrode (4) und das Phasen-Wechsel-Material (5) in einem Kontaktloch eines Dielektrikums (2) ausgebildet sind, und
die Anschlussgegenelektrode (6) an der gemeinsamen Oberfläche des Dielektrikums (2) und des Phasen-Wechsel-Materials (5) ausgebildet ist.

10. Verfahren zur Herstellung eines Phasen-Wechsel-Speicherelements mit den Schritten:
a) Ausbilden eines Dielektrikums (2) auf eine Trägerschicht (1);
b) Ausbilden einer Öffnung im Dielektrikum (2) bis zu Trägerschicht (1);
c) Ausbilden eines Anschlusselements (3) in der Öffnung;
d) Ausbilden einer Vertiefung (R) im Bereich des Anschlusselements (3);
e) Auffüllen der Vertiefung (R) mit einem Hilfsdielektrikum (HI);
f) Ausbilden einer Vielzahl von Maskierungselementen (K) zumindest an der Oberfläche des Hilfsdielektrikums (HI);
g) anisotropes Rückätzen der von den Maskierungselementen (K) nicht bedeckten Bereiche des Hilfsdielektrikums (HI) bis zum Anschlusselement (3) zum Ausbilden einer Vielzahl von Isolationsgebieten (I);
h) Auffüllen der zwischen den Isolationsgebieten (I) liegenden Bereiche mit einem Elektrodenmaterial (E) zum Ausbilden einer Anschlusselektrode (4);
i) Ausbilden eines Phasen-Wechsel-Materials (5) zumindest an der Oberfläche der Anschlusselektrode (4); und
j) Ausbilden einer Anschlussgegenelektrode (6) an der gegenüberliegenden Hauptoberfläche des Phasen-Wechsel-Materials (5).

11. Verfahren nach Patentanspruch 10,
**dadurch gekennzeichnet, dass** in Schritt a) eine erste Isolationsschicht (2A), insbesondere SiO₂, auf der Trägerschicht (1), insbesondere einem Si-Substrat, und eine zweite Isolationsschicht (2B), insbesondere Si₃N₄, auf der ersten Isolationsschicht (2A) abgeschieden wird.

12. Verfahren nach Patentanspruch 10 oder 11,
**dadurch gekennzeichnet, dass** in Schritt b) als Öffnung ein Kontaktloch mittels eines lithographischen Verfahrens ausgebildet wird.

13. Verfahren nach einem der Patentansprüche 10 bis 12,
**dadurch gekennzeichnet, dass** in Schritt c) ein elektrisch leitender Liner (3A), insbesondere Ti/TiN, an der Oberfläche der Öffnung abgeschieden und ausgeheilt wird, und darauf eine elektrisch leitende Füllschicht (3B), insbesondere W, abgeschieden wird.

14. Verfahren nach einem der Patentansprüche 10 bis 13,
**dadurch gekennzeichnet, dass** in Schritt d) das Anschlusselement (3) in der Öffnung rückgeätzt wird.

15. Verfahren nach einem der Patentansprüche 10 bis 14,
**dadurch gekennzeichnet, dass** in Schritt e) SiO₂ ganzflächig abgeschieden und planarisiert wird.

16. Verfahren nach einem der Patentansprüche 10 bis 15,
**dadurch gekennzeichnet, dass** in Schritt f) die Maskierungselemente (K) sublithographisch ausgebildet werden.

17. Verfahren nach Patentanspruch 16,
**dadurch gekennzeichnet, dass** Nano-Kristalle, insbesondere Si-Nano-Kristalle, mittels eines LPCVD-Verfahrens ganzflächig abgeschieden werden.

18. Verfahren nach Patentanspruch 16,
**dadurch gekennzeichnet, dass** HSG-Körner ganzflächig abgeschieden werden.

19. Verfahren nach einem der Patentansprüche 10 bis 18,
**dadurch gekennzeichnet, dass** in Schritt h) das Elektrodenmaterial (E) insbesondere TiN, konformal, insbesondere mittels eines ALD-Verfahrens, ganzflächig abgeschieden wird und von der gemeinsamen Oberfläche des Dielektrikums (2) und der Isolationsgebiete (I) entfernt wird.

20. Verfahren nach einem der Patentansprüche 10 bis 19,
**dadurch gekennzeichnet, dass** in Schritt i) das Phasen-Wechsel-Material (5), insbesondere GeₓSb_{y}Te_{z}, mittels eines PVD- oder CVD-Verfahrens ganzflächig abgeschieden wird.

21. Verfahren nach einem der Patentansprüche 10 bis 19,
**dadurch gekennzeichnet, dass** in Schritt i) die Anschlusselektrode (4) bis zu einer vorbestimmten Tiefe zurückgeätzt wird,
das Phasen-Wechsel-Material (5), insbesondere GeₓSb_{y}Te_{z}, mittels eines PVD- oder CVD-Verfahrens ganzflächig abgeschieden wird, und
eine Planarisierung durchgeführt wird.

22. Verfahren nach einem der Patentansprüche 10 bis 21,
**dadurch gekennzeichnet, dass** in Schritt j) die Anschlussgegenelektrode (6), insbesondere TiN, ganzflächig abgeschieden wird.

## Claims

1. Connection electrode for phase change material, having an electrically conductive electrode material (E), which has at least one connection surface (O1) for the phase change material, **characterized in that** a multiplicity of insulation regions (I) are formed within the electrode material (E) and at least at its connection surface (O1), in order to reduce the overall size of a contact surface.

2. Connection electrode according to Patent Claim 1, **characterized in that** the insulation regions (I) are sublithographically patterned, and the electrode material (E) is formed cohesively between the insulation regions (I).

3. Connection electrode according to either of Patent Claims 1 and 2, **characterized in that** the insulation regions (I) extend from the connection surface (O1) to an opposite main surface (02).

4. Connection electrode according to one of Patent Claims 1 to 3, **characterized in that** the insulation regions (I) have a grain-like structure at the connection surface (O1).

5. Connection electrode according to either of Patent Claims 3 and 4, **characterized in that** the insulation regions (I) have a cylindrical structure in cross section with respect to the connection surface (O1).

6. Connection electrode according to one of Patent Claims 1 to 5, **characterized in that** the insulation regions (I) include SiO₂ and the electrode material (E) includes TiN.

7. Phase change memory element, having
a carrier layer (1);
a connection element (3), which is electrically connected to the carrier layer (1);
a connection electrode (4) having a connection surface (O1) and an opposite main surface (02), which is electrically connected to the connection element (3);
a phase change material (5), which is formed at the connection surface (O1); and
a connection counterelectrode (6), which is formed on the phase change material (5) on the opposite side from the connection electrode (4),
**characterized in that** the connection electrode (4) and/or the connection counterelectrode (6) is formed as described in one of Patent Claims 1 to 6.

8. Phase change memory element according to Patent Claim 7, **characterized in that** the connection element (3) and the connection electrode (4) are formed in a contact hole of a dielectric (2), and the phase change material (5) is formed at the common surface of the dielectric (2) and the connection electrode (4).

9. Phase change memory element according to Patent Claim 7, **characterized in that** the connection element (3), the connection electrode (4) and the phase change material (5) are formed in a contact hole of a dielectric (2), and
the connection counterelectrode (6) is formed at the common surface of the dielectric (2) and the phase change material (5).

10. Process for producing a phase change memory element, comprising the steps of:
a) forming a dielectric (2) on a carrier layer (1);
b) forming an opening in the dielectric (2) as far as the carrier layer (1);
c) forming a connection element (3) in the opening;
d) forming a recess (R) in the region of the connection element (3);
e) filling the recess (R) with an auxiliary dielectric (HI);
f) forming a multiplicity of masking elements (K) at least at the surface of the auxiliary dielectric (HI);
g) anisotropically etching back those regions of the auxiliary dielectric (HI) which are not covered by the masking elements (K) as far as the connection element (3), to form a multiplicity of insulation regions (I);
h) filling the regions which lie between the insulation regions (I) with an electrode material (E) to form a connection electrode (4);
i) forming a phase change material (5) at least at the surface of the connection electrode (4); and
j) forming a connection counterelectrode (6) at the opposite main surface of the phase change material (5).

11. Process according to Patent Claim 10, **characterized in that** in step a) a first insulation layer (2A), in particular SiO₂, is deposited on the carrier layer (1), in particular an Si substrate, and a second insulation layer (2B), in particular Si₃N₄, is deposited on the first insulation layer (2A).

12. Process according to Patent Claim 10 or 11, **characterized in that** in step b) a contact hole is formed as the opening by means of a lithographic process.

13. Process according to one of Patent Claims 10 to 12, **characterized in that** in step c) an electrically conductive liner (3A), in particular Ti/TiN, is deposited at the surface of the opening and annealed, and an electrically conductive filling layer (3B), in particular W, is deposited thereon.

14. Process according to one of Patent Claims 10 to 13, **characterized in that** in step d) the connection element (3) is etched back in the opening.

15. Process according to one of Patent Claims 10 to 14, **characterized in that** in step e) SiO₂ is deposited over the entire surface and planarized.

16. Process according to one of Patent Claims 10 to 15, **characterized in that** in step f) the masking elements (K) are formed sublithographically.

17. Process according to Patent Claim 16, **characterized in that** nanocrystals, in particular Si nanocrystals, are deposited over the entire surface by means of an LPCVD process.

18. Process according to Patent Claim 16, **characterized in that** HSG grains are deposited over the entire surface.

19. Process according to one of Patent Claims 10 to 18, **characterized in that** in step h) the electrode material (E), in particular TiN, is deposited conformally, in particular by means of an ALD process, over the entire surface and is removed from the common surface of the dielectric (2) and the insulation regions (I).

20. Process according to one of Patent Claims 10 to 19, **characterized in that** in step i) the phase change material (5), in particular GeₓSb_{y}Te_{z}, is deposited over the entire surface by means of a PVD or CVD process.

21. Process according to one of Patent Claims 10 to 19, **characterized in that** in step i) the connection electrode (4) is etched back to a predetermined depth, the phase change material (5), in particular GeₓSb_{y}Te_{z}, is deposited over the entire surface by means of a PVD or CVD process, and
a planarization is carried out.

22. Process according to one of Patent Claims 10 to 21, **characterized in that** in step j) the connection counterelectrode (6), in particular TiN, is deposited over the entire surface.

## Revendications

1. Electrode de connexion pour du matériau à changement de phase ayant un matériau (E) d'électrode conducteur de l'électricité, qui a au moins une surface (O1) de connexion pour le matériau de changement de phase,
**caractérisée en ce qu'**une pluralité de domaines (I) isolants sont formés au sein du matériau (E) d'électrode et au moins à sa surface (01) de connexion pour diminuer une surface totale de contact.

2. Electrode de connexion suivant la revendication 1,
**caractérisée en ce que** les domaines (I) isolants sont structurés sublithographiquement et **en ce que** le matériau (E) d'électrode est d'un seul tenant entre les domaines (I) isolants.

3. Electrode de connexion suivant l'une des revendications 1 ou 2,
**caractérisée en ce que** les domaines (I) isolants s'étendent de la surface (01) de connexion jusqu'à une surface (02) principale opposée.

4. Electrode de connexion suivant l'une des revendications 1 à 3,
**caractérisée en ce que** les domaines (I) isolants ont une structure en forme de grain à la surface (O1) de connexion.

5. Electrode de connexion suivant l'une des revendications 3 ou 4,
**caractérisée en ce que** les domaines (I) isolants ont une structure de forme cylindrique en section transversale par rapport à la surface (O1) de connexion.

6. Electrode de connexion suivant l'une des revendications 1 à 5,
**caractérisée en ce que** les domaines (I) isolants ont du SiO₂ et le matériau (E) d'électrode du TiN.

7. Elément de mémoire à changement de phase comprenant
une couche (1) support ;
un élément (3) de connexion, qui est relié électriquement à la couche (1) support ;
une électrode (4) de connexion ayant une surface (O1) de connexion et une surface (02) principale qui lui est opposée et qui est reliée électriquement à l'élément (3) de connexion ;
un matériau (5) de changement de phase qui est constitué sur la surface (O1) de connexion ; et
une contre-électrode (6) de connexion, qui est formée sur le matériau (5) de changement de phase en opposition à l'électrode (4) de connexion,
**caractérisé en ce que** l'électrode (4) de connexion et/ou la contre-électrode (6) de connexion sont constituées suivant l'une des revendications 1 à 6.

8. Elément de mémoire à changement de phase suivant la revendication 7,
**caractérisé en ce que** l'élément (3) de connexion et l'électrode (4) de connexion sont formés dans un trou de contact d'un diélectrique (2) et le matériau (5) de changement de phase est formé sur la surface commune du diélectrique (2) et de l'électrode (4) de connexion.

9. Elément de mémoire à changement de phase suivant la revendication 7,
**caractérisé en ce que** l'élément (3) de connexion, l'électrode (4) de connexion et le matériau (5) de changement de phase sont formés dans un trou de contact d'un diélectrique (2) et
la contre-électrode (4) de connexion est formée sur la surface commune du diélectrique (2) et du matériau (5) de changement de phase.

10. Procédé de production d'un élément de mémoire à changement de phase, comprenant les stades dans lesquels :
a) on forme un diélectrique (2) sur une couche (14) de support ;
b) on forme une ouverture dans le diélectrique (2) jusqu'à la couche (1) de support ;
c) on forme un élément (3) de connexion dans l'ouverture ;
d) on forme une cavité (R) dans la zone de l'élément (3) de connexion ;
e) on remplit la cavité (R) d'un diélectrique (HI) auxiliaire ;
f) on forme une pluralité d'éléments (K) de masquage au moins à la surface du diélectrique (Hi) auxiliaire ;
g) on attaque en retrait de façon anisotrope les zones du diélectrique (HI) auxiliaire qui ne sont pas revêtues des éléments (K) de masquage jusqu'à l'élément (3) de connexion pour former une pluralité de domaines (I) isolants ;
h) on remplit les zones se trouvant entre les domaines (I) isolants d'un matériau (E) d'électrode pour former une électrode (4) de connexion ;
i) on forme un matériau (5) de changement de phase au moins à la surface de l'électrode de connexion ; et
j) on forme une contre-électrode (6) de connexion sur la surface principale apposée du matériau (5) de changement de phase.

11. Procédé suivant la revendication 10,
**caractérisé en ce que** dans le stade a) on dépose une première couche (2A) isolante, notamment en SiO₂, sur la couche (1) support, notamment sur un substrat en Si, et une deuxième couche (2B) isolante, notamment en Si₃N₄, sur la première couche (2A) isolante.

12. Procédé suivant la revendication 10 ou 11,
**caractérisé en ce que** dans le stade b) on forme comme ouverture un trou de contact au moyen d'un procédé lithographique.

13. Procédé suivant l'une des revendications 10 à 12,
**caractérisé en ce qu'**au stade c) on dépose un liner (3A) conducteur de l'électricité, notamment en Ti/TiN sur la surface de l'ouverture et on dépose dessus une couche (3B) de remplissage conductrice de l'électricité, notamment en W.

14. Procédé suivant l'une des revendications 10 à 13,
**caractérisé en ce qu'**au stade d) on attaque en retrait l'élément (3) de connexion dans l'ouverture.

15. Procédé suivant l'une des revendications 10 à 14,
**caractérisé en ce qu'**au stade e) on dépose sur toute la surface du SiO₂ et on le planarise.

16. Procédé suivant l'une des revendications 10 à 15,
**caractérisé en ce qu'**au stade f) on forme de manière sublithographique les éléments (K) de masquage.

17. Procédé suivant la revendication 16,
**caractérisé en ce que** l'on dépose sur toute la surface des nanocristaux, notamment des nanocristaux de Si, au moyen d'un procédé LPCVD.

18. Procédé suivant la revendication 16,
**caractérisé en ce que** l'on dépose sur toute la surface des grains de HSG.

19. Procédé suivant l'une des revendications 10 à 18,
**caractérisé en ce qu'**au stade h) on dépose sur toute la surface le matériau (E) d'électrode, notamment en TiN, d'une manière conforme, notamment au moyen d'un procédé ALD, et on l'élimine de la surface commune du diélectrique (2) et du domaine (I) isolant.

20. Procédé suivant l'une des revendications 10 à 19,
**caractérisé en ce qu'**au stade i) on dépose sur toute la surface le matériau (5) de changement de phase, notamment en GeₓSb_{y}Te_{z}, au moyen d'un procédé PVD ou CVD.

21. Procédé suivant l'une des revendications 10 à 19,
**caractérisé en ce qu'**au stade i) on attaque en retrait l'électrode (4) de connexion jusqu'à une profondeur déterminée à l'avance,
on dépose sur toute la surface le matériau (5) de changement de phase, notamment en GeₓSb_{y}Te_{z}, au moyen d'un procédé PVD ou CVD et
on effectue une planarisation.

22. Procédé suivant l'une des revendications 10 à 21,
**caractérisé en ce qu'**au stade j) on dépose sur toute la surface la contre-électrode (6) de connexion, notamment en TiN.
